# EUROPEAN PATENT SPECIFICATION

(11) **EP 0 481 715 B1**
(45) Date of publication and mention of the grant of the patent: **28.02.1996**
(21) Application number: 91309463.7
(22) Date of filing: 15.10.1991
(51) Int. Cl.: B29C 45/00, B29C 45/26

(54) **Injection moulding of plastics housings**
Spritzgiessen von Kunststoffgehäusen
Moulage par injection de boîtiers en matière plastique

(30) Priority: 15.10.1990 JP 273191/90
(43) Date of publication of application: 22.04.1992
(73) Proprietor: FUJITSU LIMITED, Kawasaki-shi, Kanagawa 211 (JP); FUJITSU KASEI LTD., Yokohama-shi Kanagawa 226 (JP)
(72) Inventor: Adachi, Katsura, Sagamihara-shi, Kanagawa 228 (JP); Usui, Makoto, Yokohama-shi, Kanagawa 233 (JP); Nishii, Kota, Isehara-shi, Kanagawa 259-11 (JP); Muraya, Takashi, Kawasaki-shi, Kanagawa 213 (JP); Kobayashi, Toshihiro, Machida-shi, Tokyo 194-02 (JP); Tamura, Kazuyuki, Mishima-shi, Shizuoka 411 (JP); Sato, Junichi, Kawasaki-shi, Kanagawa 210 (JP)
(74) Representative: Fane, Christopher Robin King

(56) References cited:
- FR-A- 2 370 569
- US-A- 3 951 375
- US-A- 4 856 704
- KUNSTSTOF EN RUBBER vol. 43, no. 5, May 1990, ROTTERDAM NL pages 26 - 30; SCHOUENBERG: 'Reologisch produkt- en matrijsholteontwerp'

## Description

This invention relates to injection moulding of plastics housings. Such plastic housing structures may be used, for example, for home electric or electronic units, toys, telephones, office automation machines, and for portable personal computers, portable wordprocessors, and the like.

In recent years, portable units, such as notebook-type personal computers and portable wordprocessors, have become lighter and lighter in weight. It should be noted that the material of the housing structures of these portable units has been changed from a heavy metal to a plastic material which is light or relatively low in specific gravity. None the less, in these products the weight of the housing has still been about one third of the total product weight. Thus, it is desirable to reduce the weights of such housing structures.

In addition, a tray-form plastic housing for a notebook-type personal computer or portable wordprocessor should preferably be strong and easy to form. In this respect, heretofore it has been desired that a thickness of the housing be as uniform as possible, for example a thickness of 3 to 5 mm, or about 2.5 mm at minimum. The specific gravity of plastics material is generally 0.95 to 2.0, and the specific gravity of plastics material of high strength is about 1.1 to 1.7. Therefore, heretofore it has been considered impractical to attempt to reduce the weight of products by reducing the weight of housing material, since it was held that this would lead to unacceptable loss of strength of the housing.

In this respect, if the thickness of the housing wall were reduced, to 1.0 to 0.7 mm for example, it is found that the following problems can arise:
1) In general, the deformation of a plate due to a bending stress varies in inverse proportion to the square of the thickness of the plate. Therefore, if the thickness of a plate is reduced by a factor of two, the deformation thereof (under a given load) will be increased four times. In this way, if the thickness of a plate is reduced it becomes too easily deformable and the housing could become too weak to protect the contents thereof.
2) If the thickness of a housing wall is reduced, when the housing is made by injection moulding the melted resin must flow into a cavity which has a thin, wide area. Thus, a resistance to flow becomes very high and a pressure necessary for bringing about flow also becomes high. Therefore, an injection moulding machine having a large injection capacity must be used. Also, if the pressure is increased, a large force is exerted on the mould, possibly causing the mould to open, so that a variation of thickness of the housing wall can occur and fins can be generated. In addition, if the thickness of a housing wall is thin, the heated, molten resin comes into contact widely with the inner wall of the mould cavity, when flowing therein, so that the resin is rapidly cooled and thus the temperature of the resin is lowered. This means that the viscosity of the resin is increased and thus a part of resin might become solid before having reached the terminal portions of the mould product. This leads to a so-called "short shot".
3) In order to prevent the above-mentioned variations and "short shot", the thickness of the housing wall can be increased at peripheral portions thereof and the product can be provided with ribs which serve as passages for the molten resin when forming the same by moulding. Such an approach is described, for example, in "Kunststoff & Rubber", 1990, nummer 5, p. 26-30. Then, however, the following secondary problems can arise. Namely, the resin will first flow into the portions of low resistance, i.e. the peripheral portions and the ribs, so that gas which could not be discharged to the outside, accumulates at a bottom wall and thin wall portions of the housing and, therefore, a so-called "burned mark (spot)" will arise due to "short shot" or a compression of gas. These, and other problems, are discussed in US 3951375, for example, which proposes the use of a balanced runner system, for admitting molten polymer material to the mould cavity, having five gates. However, no method is disclosed of producing a housing in which the side walls are thicker than the base.
4) If the product has a thin wall portion and, in a final discharge process for taking the product out of the metal mould, the product is pushed by the wall portion thereof in the normal manner, the thin wall portion may be damaged or deformed by a pusher, since such a portion has not yet solidified sufficiently.

According to a first aspect of the present invention there is provided a plastics tray-form housing member, comprising a substantially flat base panel provided around the periphery thereof with wall portions that project from one main face of the base panel to form an upstanding side wall structure extending substantially completely around the said one main face,
characterised in that the said wall portions are in the range from 3/2 to 3 times as thick as the said base panel. The housing member may be made, for example, by injection moulding from a resin material.

In one embodiment, an average thickness of the said side wall structure is less than or equal to 3.0 mm.

It is advantageous that the total area of the inward-facing surfaces of the said side wall structure is not more than one half of the area of the said one main face.

Preferably, the said base panel has at least one rib structure at its said one main face.

According to another aspect of the present invention there is provided a mould structure, for use in a process of producing a housing member having such a rib structure by injection moulding, having a mould cavity the shape and dimensions of which conform to those of the housing member to be produced, and also having on a surface thereof bounding the said mould cavity one or more grooves corresponding respectively to the rib structure(s) of the moulded housing member.

The or each rib structure is preferably provided with a cylindrical boss, having a main axis that is substantially perpendicular to the said one main face, and formed with a hole in it for receiving a screw, preferably a self-tapping screw. The boss can also be used for extruding the moulded product from a mould structure used to form it.

It is advantageous that the housing member has two rib structures that cross at an intersection point on the said one main face, and also has such a cylindrical boss at the said intersection point. The boss also serves for extruding said moulded product from the mould structure.

Preferably, the mould structure described above further comprises a cylindrical sleeve-like knockout member mounted movably with respect to the mould structure and actuable upon completion of the injection moulding process to push against the said cylindrical boss of the moulded housing member so as to facilitate removal of that member from the mould structure.

In an injection moulding process embodying a further aspect of the present invention and employing such a mould structure, the said cylindrical sleeve-like knockout member is actuated, after the plastics material injected into the mould cavity has set, to push against the said cylindrical boss of the moulded housing member so as to facilitate removal of that member from the mould structure.

According to another aspect of the present invention there is provided a mould structure, for use in a process of producing a housing member as described above by injection moulding, comprising:
two mould portions which, when placed together, define therebetween a mould cavity the shape and dimensions of which conform to those of the housing member to be produced; and
at least two injection gates, provided on that one of the mould portions which upon completion of the moulding process will be adjacent to the said one main face of the moulded housing member, for admitting plastics material into the said mould cavity.

In one embodiment, for producing a housing member having a rib structure as described above, the said one mould portion has, on a surface thereof bounding the said mould cavity, one or more grooves corresponding respectively to the rib structure(s) of the moulded housing member, and the said injection gates are located on the said groove(s).

Preferably, the said one mould portion is also provided with at least one telescopic or knockout pin positioned and adapted for venting gas from one or more predetermined portions of the mould cavity which the plastics material reaches last when injected into the cavity during the moulding process. The or each telescopic or knockout pin is advantageously located on one of the grooves.

Reference will now be made, by way of example, to the accompanying drawings, in which:
Figure 1(a) is a schematic perspective view of a housing structure, Figure 1(b) is a cross-sectional view taken along a line b-b in Fig. 1(a), and Figure 1(c) is a view corresponding to Fig. 1(b) but showing an alternative construction of the housing structure of Fig. 1(a);
Figure 2(a) is a plan view of a housing structure embodying one aspect of this invention, and Figure 2(b) is a cross-sectional view taken along a line b-b in Fig. 2(a);
Figure 3(a) is a perspective view of a comparable housing structure to that of Fig. 2, having an upright wall of a first thickness, and Figure 3(b) is a perspective view of the housing structure of Fig. 2 having an upright wall of a second thickness different from the first;
Figure 4 shows a result of a simulation of resin flow in a mould structure;
Figure 5 is a cross-sectional view of a mould structure embodying another aspect of the present invention;
Figure 6(a) shows a perspective view of a boss (or knockout pin structure) that may be included in a housing structure embodying the invention, and Fig. 6(b) shows a sectional view of the boss of Fig. 6(a);
Figures 6(c) and 6(d) show respective sectional views of the boss of rig. 6(a) illustrating different stages in a step in a moulding process employing the mould structure of Fig. 5; and
Figure 7 is a plan view of another housing structure (a lower cover) embodying the invention, for use in a notebook-type personal computer.

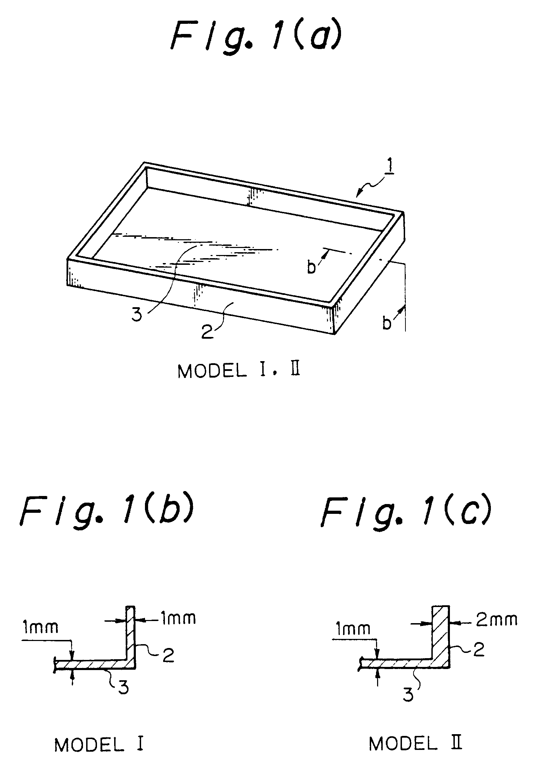

The tray-form plastic housing structure 1 of Fig. 1(a) comprises a substantially flat bottom wall 3 and an upright wall 2 extending upward from the peripheral edge of the bottom wall 3. The bottom wall 3 and the upright wall 2 cooperatively define an integral box-shaped housing structure. In the housing structure shown in Figs. 1(a) and 1(b), the thickness of the bottom wall 3 is substantially the same as the thickness of the peripheral upright wall 2 and the surface area of the upright wall 2 is not more than one half of the area of the bottom wall 3.

In an experiment, an external bending and twisting force was exerted on the housing structure shown in Figs. 1(a) and 1(b), and an internal stress caused by the external force was monitored. From the results, it was found that a relatively large stress was generated on the peripheral upright wall 2, but almost no stress was generated on the bottom wall 3 having relatively large surface area.

In the alternative structure shown in Fig. 1(c), the thickness of the peripheral upright wall 2 was increased (relative to the Fig. 1(b) structure) to distribute the stress and, on the other hand, the thickness of the bottom wall 3 was reduced (as compared to the above-mentioned conventional housing thickness of 3 to 5mm) since it does not directly bear the stress, so that the entire volume of the housing wall, and thus the weight of the housing, could be kept desirably low. Thus, deformation caused by an external force was reduced as compared to the Fig. 1(b) structure.

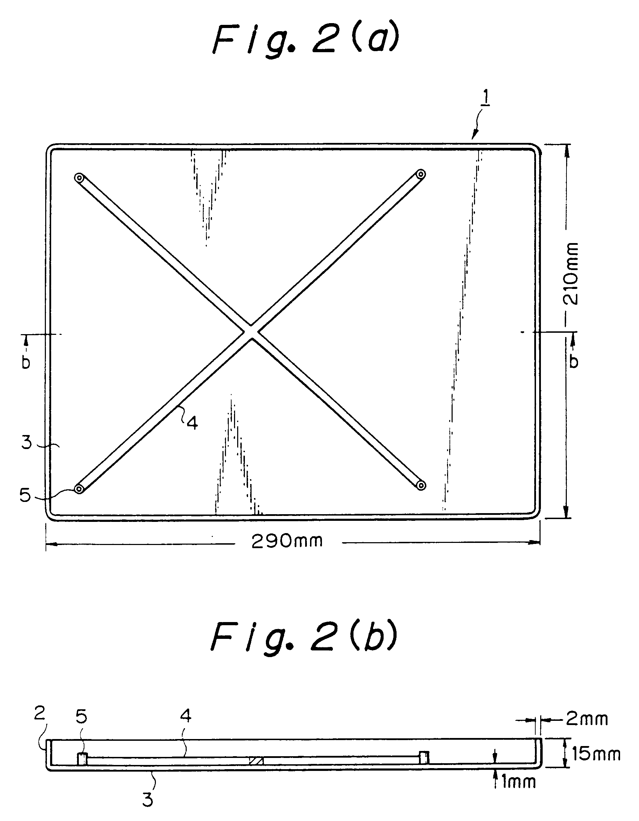

Figure 2(a) is a plan view of the moulded product of a housing structure embodying the present invention, and Fig. 2(b) is a cross-sectional view taken along line b-b in Fig. 2(a).

Such a structure may be used as a body cover (housing) of a notebook-type personal-use computer which is A4 sized, and has a bottom wall 3 of 1.0 mm thickness, a peripheral upright wall 2 of 15 mm height and 2.0 mm thickness, and X-shaped cross ribs 4 on the bottom wall 3. This housing was made by an injection moulding from a new material, for example denatured or modified polyphenylene oxide containing carbon fibers. Several cylindrical bosses 5 may be provided on the ribs 4 for receiving screws (in particular self-tapping screws), snap fittings, or insert threads, for fixing a printed circuit board, connectors, or a housing cover.

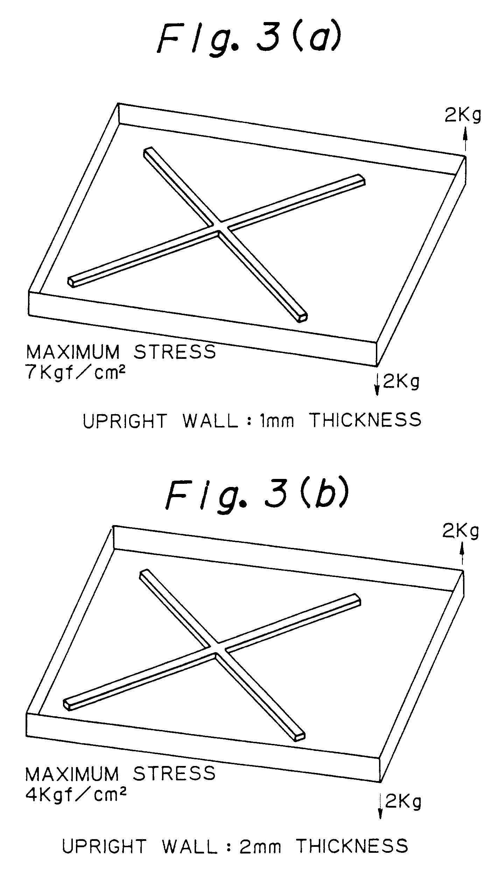

In a simulated model of the moulded product of a housing structure according to Fig. 2, a resistance force against deformation was simulated. In Fig. 3(a), a structure generally as shown in Fig. 2 was used, but in this comparative example the thickness of the bottom wall 3 and the thickness of the peripheral upright wall 2 are both 1.0 mm. The left side periphery of the housing was taken to be completely fixed and the effects of a twisting force exerted on the right side periphery of the housing were simulated, i.e. an upward force of 2 kg was exerted on the right rear corner thereof and, on the other hand, a downward force of 2 kg was exerted on the right front corner thereof. In Fig. 3(b), the thickness of the peripheral upright wall 2 was 2.0 mm (as in Fig. 2) and the other conditions were the same as Fig. 3(a).

The results were as follows. In the structure of Fig. 3(a) a maximum deformation was 5.3 mm at the right front corner and a maximum internal stress was 7 kgf/cm² at the left side periphery. However, in the structure of Fig. 3(b) a maximum deformation was 3.1 mm and a maximum internal stress was 4 kgf/cm². Thus, both the maximum deformation and the maximum internal stress were significantly reduced.

In addition, a sample of the above-discussed comparative example of the housing (Fig. 3(a)), in which the thickness of the peripheral upright wall 2 was 1.0 mm, was made in the same manner as the Fig. 2 housing. Then, in a comparative test of the structures of Figs. 3(a) and 3(b), the left side periphery of each sample thus made was completely fixed. A twisting force was exerted on the right side periphery of the housing, i.e. a downward force of 2 kg was exerted on the right front corner thereof and, on the other hand, an upward force of 2 kg was exerted on the right rear corner thereof. A stress generated in the housing and a deformation thereof were measured by a monitoring robot. The results were as follows. A maximum deformation of the Fig. 2 (Fig. 3(b)) structure was 3.0 mm, but a maximum deformation of the comparative example of Fig. 3(a) was 5.8 mm. It should be noted that the results were quite similar to the results of the simulation discussed above with reference to Figs. 3(a) and 3(b). In the structure of Fig. 2, the deformation could be significantly reduced (as compared to the comparative example) by increasing the thickness of the peripheral upright wall 2 only by 1.0 mm, with an increase of the weight of only 10 g.

If the thickness of the bottom wall 3 was less than 0.6 mm, a housing having a large bottom wall could not be readily obtained. On the other hand, if the thickness of the bottom wall 3 was more than 2.5 mm, it would be impossible to obtain a desirably lightweight housing (as compared with a conventional housing). If the thickness of the peripheral upright wall 2 was increased to more than 3.0 mm, it would also be impossible to reduce the weight of the housing, although the strength thereof could be increased.

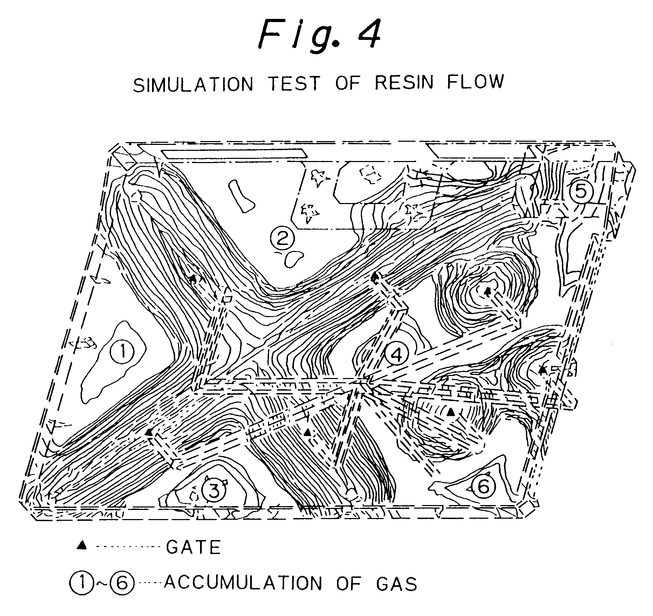

Figure 4 shows the results of a simulation of resin flow in a mould structure. In Fig. 4, the work is a housing for a notebook-type personal-use computer which is A4 sized and has a bottom wall 3 of 1.0 mm thickness and a peripheral upright wall 2 of 10 mm height. The rear portion of this peripheral upright wall 2 has 18 mm height and is provided with a mounting hole for a connector, for example. The bottom wall 3 is provided with X-shaped cross ribs 4 of 5 x 5 mm. Also, four gates are arranged on the ribs and three gates (gates are indicated by triangle marks as shown in Fig. 4) are arranged on the thin plate portion of 1.0 mm thickness where not provided with ribs 4 to facilitate flowing of the molten plastic in that area. Each of the gates arranged on the thin plate is provided with a button-like receiving portion. The results of the simulation were, as shown in Fig. 4, that when the resin is introduced to the mould cavity through the seven gates, the bottom wall is formed with six flow ends ① to ⑥ where gas accumulates.

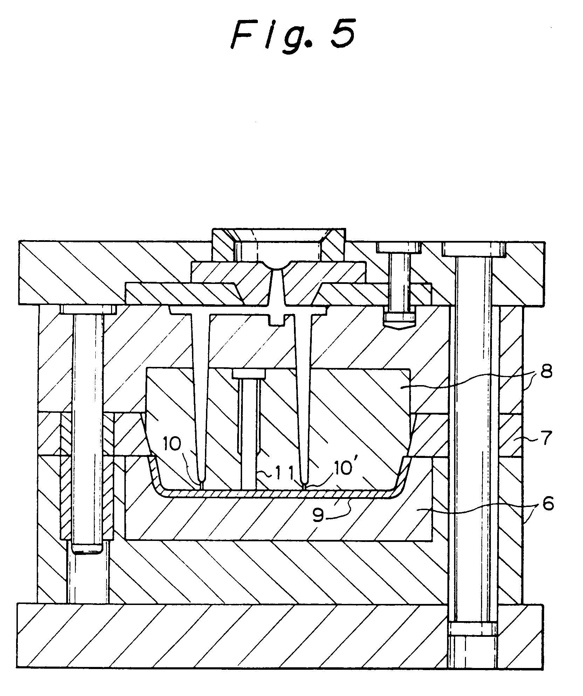

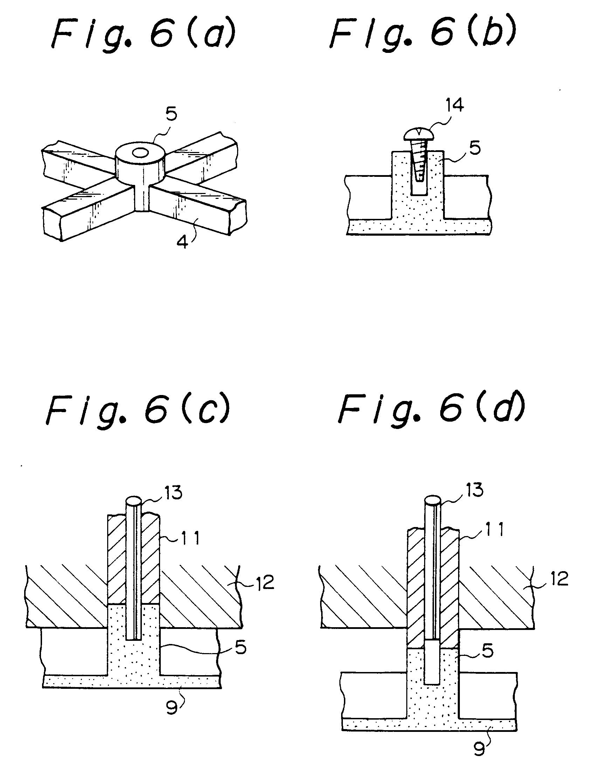

Figure 5 is a cross-sectional view of a mould structure embodying the present invention and Figs. 6(a), (b), (c), and (d) relate to a boss or knockout pin structure. The mould structure shown in Fig. 5 comprises a lower mould 6, an intermediate mould 7, and an upper mould 8. A moulded product 9 is formed in a cavity defined in the mould structure by the moulds 6, 7 and 8. The upper mould 8 is provided with gates 10 and 10′ and, at locations corresponding to the positions of gas accumulation in the moulded product 9, with knockout pins 11 each having a tip of sintered metal.

In an injection moulding of a plastic housing 1 such as that of Figs. 2(a) and 2(b), if the knockout pins 11 were arranged only on the thin wall portion (the bottom wall 3), the moulded product 9 would be pushed at its weak positions and, thus, a deformation would be increased. Therefore, in an embodiment of the present invention the moulded product 9 is formed with cylindrical bosses 5, as shown in Fig. 6(a), at end or intermediate positions along the ribs 4 or at the intersections thereof, to serve as a main "knockout", and, as shown in Fig. 6(c), the mould 12 (upper mould 8 in Fig. 5) is provided with sleeve-like knockout pins 11 and fixing pins 13. When the moulded product 9 is to be pushed out of the cavity, these cylindrical bosses 5 are pushed by a cylindrical sleeve or knockout pin as shown in Figs. 6(c) and 6(d), so that the exerted force can be dispersed by the ribs 4 to the thin wall portion (bottom wall 3) and, therefore, the deformation can be kept desirably low. The cylindrical bosses 5 thus formed by the mould can be used for receiving screws (in particular self-tapping screws), snap fittings, or insert threads, for fixing a printed circuit board, connectors, or a housing cover, as shown in Fig. 6(b).

In the mould structure of Fig. 5, the rib portions 4 and a relatively thick peripheral upright wall 2 are used as passageways for the molten resin during injection moulding and, therefore, the gates 10 and 10′ can be arranged on the rib portions 4 or on at least two positions in the vicinity of the peripheral upright wall 2, so that the resin can flow more smoothly. Also, at positions on the bottom wall which the resin finally reaches (terminal portions), telescopic or knockout pins, each having a structure for venting the air (for example, a structure having a gap, a groove-like vent, sintered alloy, or the like), are provided. Thus, a resin firing due to overheating of the resin by a short shot or adiabatic compression of the air can be prevented.

Thus, using a mould structure embodying the present invention a thin moulded product can be obtained without significant problems due to short shot, deformation or gas-firing. In a housing embodying the invention used for a notebook-type computer, a weight of the housing can be reduced to about 350 g by reducing the thickness of the main wall to 1.0 mm, as compared with a conventional type housing having a weight of about 750 g. In this case, the deformation of such a housing embodying the invention, due to an external force, is substantially the same as a conventional housing.

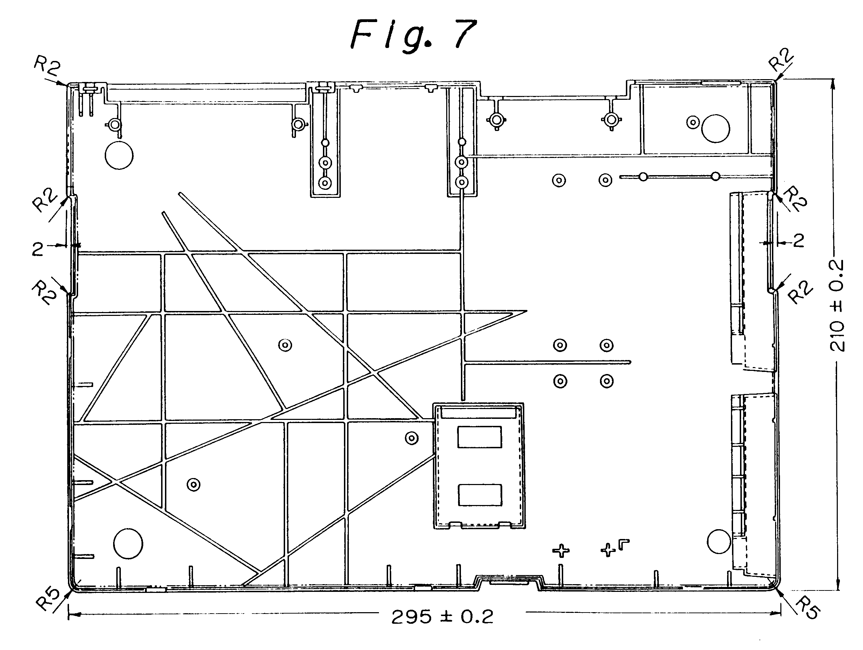

Figure 7 is a plan view of a housing structure embodying the invention, namely a lower cover of a personal-use notebook-type computer. As will be seen in Fig. 7, the shape of this housing is more complicated in comparison with the embodiment shown in Figs. 2(a) and (b). In the Fig. 7 housing, the thickness of the bottom wall is in the range from one third to two thirds of the thickness of the peripheral upright wall, for example the thickness of the bottom wall may be 1.0 mm and the thickness of the peripheral upright wall may be 2.0 mm. There are many ribs in this example and, in the same manner as the above, these ribs can be used as passageways for facilitating the flow of melted resin.

## Claims

1. A plastics tray-form housing member, comprising a substantially flat base panel (3) provided around the periphery thereof with wall portions that project from one main face of the base panel (3) to form an upstanding side wall structure (2) extending substantially completely around the said one main face,
characterised in that the said wall portions are in the range from 3/2 to 3 times as thick as the said base panel.

2. A housing member as claimed in claim 1, wherein the total area of the inward-facing surfaces of the said side wall structure (2) is not more than one half of the area of the said one main face.

3. A housing member as claimed in claim 1 or 2 that has been made by injection moulding from a resin material.

4. A housing member as claimed in any preceding claim, wherein an average thickness of the said side wall structure (2) is less than or equal to 3.0 mm.

5. A housing member as claimed in any preceding claim, wherein the said base panel (3) has at least one rib structure (4) at its said one main face.

6. A housing member as claimed in claim 5, wherein the or each rib structure (4) is provided with a cylindrical boss (5), having a main axis that is substantially perpendicular to the said one main face, and formed with a hole in it for receiving a screw, preferably a self-tapping screw.

7. A housing member as claimed in claim 6, having two rib structures (4) that cross at an intersection point on the said one main face, and also having such a cylindrical boss (5) at the said intersection point.

8. A mould structure, for use in a process of producing a housing member as claimed in any preceding claim by injection moulding, comprising:
two mould portions (6,8) which, when placed together, define therebetween a mould cavity the shape and dimensions of which conform to those of the housing member to be produced; and
at least two injection gates (10, 10'), provided on that one (8) of the mould portions which upon completion of the moulding process will be adjacent to the said one main face of the moulded housing member (9), for admitting plastics material into the said mould cavity.

9. A mould structure as claimed in claim 8, for use in an injection moulding process to produce a housing member as claimed in claim 5, wherein the said one mould portion (8) has, on a surface thereof bounding the said mould cavity, one or more grooves corresponding respectively to the rib structure(s) of the moulded housing member (9), and the said injection gates (10,10') are located on the said groove(s).

10. A mould structure as claimed in claim 8 or 9, wherein the said one mould portion (8) is also provided with at least one telescopic or knockout pin (13) positioned and adapted for venting gas from one or more predetermined portions of the mould cavity which the plastics material reaches last when injected into the cavity during the moulding process.

11. A mould structure as claimed in claim 10 when read as appended to claim 9, wherein the or each telescopic or knockout pin (13) is located on the said groove(s).

12. An injection moulding process of producing a housing member as claimed in any one of claims 1 to 7 using a mould structure as claimed in any one of claims 8 to 11, which process comprises:
placing the two mould portions (6, 8) of the mould structure together to define such a mould cavity therebetween, and
injecting plastics material into the mould cavity via the said injection gates (10, 10') simultaneously.

13. A mould structure, for use in a process of producing a housing member as claimed in claim 5 by injection moulding, having a mould cavity the shape and dimensions of which conform to those of the housing member to be produced, and also having on a surface thereof bounding the said mould cavity one or more grooves corresponding respectively to the rib structure(s) of the moulded housing member (9).

14. A mould structure as claimed in claim 13, for use in a process of producing a housing member as claimed in claim 6 or 7 by injection moulding, further comprising a cylindrical sleeve-like knockout member (11) mounted movably with respect to the mould structure and actuable upon completion of such an injection moulding process to push against the said cylindrical boss of the moulded housing member (9) so as to facilitate removal of that member from the mould structure.

15. An injection moulding process of producing a housing member as claimed in claim 6 or 7 using a mould structure as claimed in claim 14, in which process the said cylindrical sleeve-like knockout member (11) is actuated, after the plastics material injected into the mould cavity has set, to push against the said cylindrical boss of the moulded housing member (9) so as to facilitate removal of that member from the mould structure.

## Patentansprüche

1. Ein wannenförmiges Gehäuseteil aus Kunststoff, umfassend eine im wesentlichen flache Basisplatte (3), die um ihre Peripherie herum mit Wandabschnitten versehen ist, die von einer Hauptseite der Basisplatte (3) abstehen und eine nach oben stehende Seitenwandstruktur (2) bilden, die sich im wesentlichen vollständig um diese eine Hauptseite herum erstreckt, dadurch **gekennzeichnet**, daß diese Wandabschnitte größenordnungsmäßig 3/2 bis 3 mal so dick wie die Basisplatte sind.

2. Gehäuseteil nach Anspruch 1, bei welchem der gesamte Flächenbereich der nach innen gerichteten Oberflächen der genannten Seitenwandstruktur (2) nicht mehr als einhalb des Flächenbereiches der genannten einen Hauptseite ist.

3. Gehäuseteil nach Anspruch 1 oder 2, welches durch Spritzgießen aus einem Harzmaterial hergestellt ist.

4. Gehäuseteil nach einem der vorangehenden Ansprüche, bei welchem eine durchschnittliche Dicke der genannten Seitenwandstruktur (2) kleiner als oder gleich 3,0 mm ist.

5. Gehäuseteil nach einem der vorangehenden Ansprüche, bei welchem die genannte Basisplatte (3) wenigstens eine Rippenstruktur (4) an ihrer genannten einen Hauptseite hat.

6. Gehäuseteil nach Anspruch 5, bei welchem die oder jede Rippenstruktur (4) mit einem zylindrischen Sockel (5) versehen ist, mit einer Hauptachse, die im wesentlichen senkrecht zu der genannten einen Hauptseite steht, und in welchem eine Öffnung zum Aufnehmen einer Schraube, vorzugsweise einer selbstschneidenden Schraube ausgebildet ist.

7. Gehäuseteil nach Anspruch 6, welcher zwei Rippenstrukturen (4) auf dieser einen Hauptseite hat, die sich an einem Schnittpunkt kreuzen, und welcher auch einen solchen zylindrischen Sockel (5) an dem genannten Schnittpunkt aufweist.

8. Formstruktur zur Verwendung in einem Prozeß zur Herstellung eines Gehäuseteils entsprechend einem der vorangehenden Ansprüche durch Spritzgießen, umfassend:
zwei Formabschnitte (6, 8), die dann, wenn sie zusammengesetzt sind, zwischen sich einen Formhohlraum definieren, dessen Form und Abmessungen denen des herzustellenden Gehäuseteils entsprechen; und
wenigstens zwei Einspritzöffnungen (10, 10'), die an diesem einen (8) der Formabschnitte ausgebildet sind, welcher nach Vollendung des Formprozesses an der genannten einen Hauptseite des geformten Gehäuseteils (9) liegt, um Kunststoffmaterial in den genannten Formhohlraum einzulassen.

9. Formstruktur nach Anspruch 8, zur Verwendung in einem Spritzgießprozeß zur Herstellung eines Gehäuseteils gemäß Anspruch 5, bei welcher der genannte eine Formabschnitt (8) an einer den genannten Formhohlraum begrenzenden Oberfläche desselben eine oder mehrere Nuten aufweist, die jeweils der (den) Rippenstruktur(en) des geformten Gehäuseteils (9) entsprechen, und bei welcher die genannten Einspritzöffnungen (10, 10') auf dieser (diesen) Nut(en) angeordnet sind.

10. Formstruktur nach Anspruch 8 oder 9, bei welcher der genannte eine Formabschnitt (8) auch mit wenigstens einem Teleskop- oder Ausstoßstift (13) ausgestattet ist, welcher so angeordnet und ausgebildet ist, daß er Gas von einem oder mehreren vorgegebenen Abschnitten des Formhohlraums ablassen kann, welche das Kunststoffmaterial zuletzt erreicht, wenn es beim Formprozeß in den Hohlraum eingespritzt wird.

11. Formstruktur nach Anspruch 10 im Zusammenhang mit Anspruch 9, bei welcher der oder jeder Teleskop- oder Ausstoßstift (13) auf der (den) genannten Nut(en) angeordnet ist.

12. Spritzgießprozeß für die Herstellung eines Gehäuseteils gemäß einem der Ansprüche 1 bis 7, unter Verwendung einer Formstruktur gemäß einem der Ansprüche 8 bis 11, wobei der Prozeß umfaßt:
Zusammensetzen der beiden Formabschnitte (6, 8) der Formstruktur, um einen derartigen Formhohlraum dazwischen zu bilden, und
Einspritzen von Kunststoffmaterial in den Formhohlraum gleichzeitig über die genannten Einspritzöffnungen (10, 10').

13. Formstruktur zur Verwendung in einem Prozeß zum Herstellen eines Gehäuseteils gemäß Anspruch 5 durch Spritzgießen, mit einem Formhohlraum, dessen Form und Abmessungen denen des herzustellenden Gehäuseteils entsprechen, und welche auch auf einer den genannten Formhohlraum begrenzenden Oberfläche eine oder mehrere Nuten hat, die jeweils der (den) Rippenstruktur(en) des geformten Gehäuseteils (9) entsprechen.

14. Formstruktur nach Anspruch 13, zur Verwendung in einem Prozeß zum Herstellen eines Gehäuseteils gemäß den Ansprüchen 6 oder 7 durch Spritzgießen, welche ferner ein zylindrisches, hülsenartiges Ausstoßelement (11) umfaßt, welches gegenüber der Formstruktur verstellbar angeordnet und nach Vollendung eines derartigen Spritzgießprozesses so betätigbar ist, daß es gegen den genannten zylindrischen Sockel des geformten Gehäuseteils (9) drückt, um so ein Entfernen dieses Teils aus der Formstruktur zu erleichtern.

15. Spritzgießprozeß zum Herstellen eines Gehäuseteils gemäß Anspruch 6 oder 7, unter Verwendung einer Formstruktur gemäß Anspruch 14, bei welchem Prozeß das genannte zylindrische, hülsenartige Ausstoßelement (11) betätigt wird, nachdem das in den Formhohlraum eingespritzte Kunststoffmaterial abgebunden hat, um gegen den genannten zylindrischen Sockel des geformten Gehäuseteils (9) zu drücken, um auf diese Weise ein Entfernen dieses Teils aus der Formstruktur zu erleichtern.

## Revendications

1. Elément de boîtier en forme de bac en matière plastique, comprenant un panneau de fond sensiblement plat (3) muni le long de sa périphérie de parties de paroi qui font saillie sur une première face principale du panneau de fond (3) pour former une structure de paroi latérale redressée (2) s'étendant sensiblement sur tout le tour de ladite première face principale,
caractérisé en ce que lesdites parties de paroi sont d'une épaisseur comprise dans l'intervalle allant de 3/2 à 3 fois celle dudit panneau de fond.

2. Elément de boîtier selon la revendication 1, dans lequel la superficie totale des surfaces de ladite structure de paroi latérale (2) qui regardent vers l'intérieur n'est pas supérieure à la moitié de la superficie de ladite première face principale.

3. Elément de boîtier selon la revendication 1 ou 2, qui a été fabriqué par moulage par injection en résine.

4. Elément de boîtier selon une quelconque des revendications précédentes, dans lequel l'épaisseur moyenne de ladite structure de paroi latérale (2) est inférieure ou égale à 3,0 mm.

5. Elément de boîtier selon une quelconque des revendications précédentes, dans lequel ledit panneau de fond (3) a au moins une structure de nervure (4) sur ladite première face principale.

6. Elément de boîtier selon la revendication 5, dans lequel la ou chaque structure de nervure (4) est munie d'un bossage cylindrique (5) ayant un axe principal qui est sensiblement perpendiculaire à ladite première face principale et présentant intérieurement un trou pour recevoir une vis, de préférence une vis auto-taraudeuse.

7. Elément de boîtier selon la revendication 6, ayant deux structures de nervures (4) qui se croisent en un point d'intersection sur ladite première face principale, et ayant aussi un bossage cylindrique (5) audit point d'intersection.

8. Structure de moule destinée à être utilisée dans un procédé de production d'un élément de boîtier selon une quelconque des revendications précédentes par moulage par injection, comprenant :
deux parties de moule (6, 8) qui, lorsqu'elles sont placées ensemble, définissent entre elles une empreinte de moule dont la forme et les dimensions correspondent à celles de l'élément de boîtier à produire ; et
au moins deux entrées d'injection (10, 10'), prévues sur celle (8) des parties de moule qui, lors de l'achèvement de l'opération de moulage, sera adjacente à ladite première face principale de l'élément de boitier moulé (9) pour admettre la matière plastique dans ladite empreinte de moule.

9. Structure de moule selon la revendication 8, destinée à être utilisée dans un procédé de moulage par injection pour produire un élément de boîtier selon la revendication 5, dans lequel ladite partie de moule (8) possède, sur sa surface qui délimite ladite empreinte de moule, une ou plusieurs rainures qui correspondent respectivement à la structure de nervure ou aux structures de nervures de l'élément de boîtier moulé (9), et lesdites entrées d'injection (10, 10') sont placés sur ladite rainure ou sur lesdites rainures.

10. Structure de moule selon la revendication 8 ou 9, dans laquelle ladite partie de moule (8) est aussi munie d'une tige télescopique ou d'éjection (13) positionnée et adaptée pour laisser s'échapper les gaz d'une ou plusieurs parties prédéterminées de l'empreinte de moule que la matière plastique atteint en dernier lieu lorsqu'elle est injectée dans l'empreinte pendant l'opération de moulage.

11. Structure de moule selon la revendication 10, rattachée à la revendication 9, dans laquelle la ou chaque tige télescopique ou d'éjection (13) est placée sur ladite rainure ou sur lesdites rainures.

12. Procédé de moulage par injection pour produire un élément de boîtier selon une quelconque des revendications 1 à 7 en utilisant une structure de moule selon une quelconque des revendications 8 à 11, lequel procédé consiste à :
rapprocher les deux parties de moule (6, 8) de la structure de moule l'une de l'autre pour définir une empreinte de moule entre elles, et
injecter simultanément une matière plastique dans l'empreinte de moule à travers lesdites entrées d'injection (10,10').

13. Structure de moule destinée à être utilisée dans un procédé de production d'un élément de boitier selon la revendication 5 par moulage par injection, ayant une empreinte de moule dont la forme et les dimensions correspondent à celles de l'élément de boîtier à produire et ayant aussi sur une de ses surfaces qui limitent ladite empreinte de moule, une ou plusieurs rainures qui correspondent respectivement à la structure de nervure ou aux structures de nervures de l'élément de boîtier moulé (9).

14. Structure de moule selon la revendication 13, destinée à être utilisée dans un procédé de production d'un élément de boîtier selon la revendication 6 ou 7 par moulage par injection, comprenant en outre un élément d'éjection en forme de manchon cylindrique (11) monté mobile par rapport à la structure du moule et pouvant être actionné à la suite de l'achèvement d'une telle opération de moulage par injection pour exercer une poussée contre ledit bossage cylindrique de l'élément de boîtier moulé (9) de manière à faciliter l'éjection dudit élément de la structure de moule.

15. Procédé de moulage par injection pour produire un élément de boîtier selon la revendication 6 ou 7 en utilisant une structure de moule selon la revendication 14, procédé dans lequel l'élément d'éjection en forme de manchon cylindrique (11) est actionné après que la matière plastique injectée dans l'empreinte du moule s'est durcie, pour exercer une poussée contre ledit bossage cylindrique de l'élément de boîtier moulé (9) afin de faciliter l'éjection dudit élément hors de la structure de moule.
